(19) Europäisches Patentamt / European Patent Office / Office européen des brevets

(11) **EP 2 893 559 B1**

(12) **FASCICULE DE BREVET EUROPEEN**

(45) Date de publication et mention
de la délivrance du brevet:
**08.01.2020 Bulletin 2020/02**

(21) Numéro de dépôt: **13782821.6**

(22) Date de dépôt: **03.09.2013**

(51) Int Cl.:
***H01L 21/762*** *(2006.01)*

(86) Numéro de dépôt international:
**PCT/IB2013/001906**

(87) Numéro de publication internationale:
**WO 2014/037784 (13.03.2014 Gazette 2014/11)**

(54) **PROCÉDÉ DE FABRICATION D'UNE STRUCTURE EN VUE D'UNE SÉPARATION ULTÉRIEURE**

VERFAHREN ZUR HERSTELLUNG EINER STRUKTUR ZUR ANSCHLIESSENDEN TRENNUNG

METHOD FOR MANUFACTURING A STRUCTURE WITH A VIEW TO SUBSEQUENT SEPARATION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.09.2012 FR 1258394**

(43) Date de publication de la demande:
**15.07.2015 Bulletin 2015/29**

(73) Titulaire: **Soitec**
**38190 Bernin (FR)**

(72) Inventeur: **LANDRU, Didier**
**F-38190 Le Champ-Prés-Froges (FR)**

(74) Mandataire: **Grünecker Patent- und
Rechtsanwälte
PartG mbB
Leopoldstraße 4
80802 München (DE)**

(56) Documents cités:
**FR-A1- 2 857 983     US-A1- 2010 282 323**

EP 2 893 559 B1

## Description

### DOMAINE DE L'INVENTION

L'invention concerne un procédé de fabrication d'une structure par assemblage d'au moins deux substrats, l'un au moins de ces deux substrats étant destiné à être utilisé dans l'électronique, l'optique, l'optoélectronique et/ou le photovoltaïque, en vue d'une séparation ultérieure des substrats selon une interface de séparation prédéterminée.

### ARRIERE PLAN DE L'INVENTION

Un cas particulier d'une telle structure est une structure « décollable » (« debondable structure » selon la terminologie anglo-saxonne), dans laquelle l'interface de séparation est une interface selon laquelle un collage par adhésion moléculaire a été réalisé.

Par « collage par adhésion moléculaire », on désigne un collage par contact intime des surfaces des deux substrats, mettant en œuvre des forces d'adhésion, principalement les forces de Van der Walls, et n'utilisant pas de couche adhésive.

Sans vouloir être limitatif, on peut toutefois considérer qu'une structure décollable peut être utilisée principalement dans quatre applications différentes :

a) collage d'un raidisseur mécanique : il peut être souhaitable de coller un raidisseur mécanique sur un substrat ou une couche mince fragile pour éviter son endommagement ou sa rupture durant certaines étapes de fabrication, puis de pouvoir retirer ce raidisseur mécanique lorsque sa présence n'est plus nécessaire.

b) rectification d'un mauvais collage : le décollement permet de décoller deux substrats qui n'auraient pas été collés correctement une première fois, puis de les recoller après nettoyage, afin d'améliorer la rentabilité d'un procédé de fabrication et d'éviter par exemple la mise au rebut de substrats mal collés.

c) protection temporaire : lors de certaines étapes de stockage ou de transport de substrats, notamment dans des boites en matière plastique, il peut être utile de protéger temporairement leurs surfaces, notamment celles destinées à être utilisées ultérieurement pour la fabrication de composants électroniques, afin d'éviter tout risque de contamination. Une solution simple consiste à coller deux substrats de façon que leurs faces à protéger soient collées respectivement l'une avec l'autre, puis à décoller ces deux substrats lors de leur utilisation finale.

d) double transfert d'une couche : il consiste à réaliser une interface de collage réversible entre une couche active et un premier substrat support (éventuellement réalisé en un matériau coûteux), puis à transférer cette couche active sur un second substrat définitif, par décollement de ladite interface de collage réversible.

Cependant, il peut également se trouver des applications dans lesquelles on souhaite séparer une structure, formée de deux substrats assemblés, selon une interface qui n'est pas une interface de collage.

Une telle interface peut être, par exemple, une interface entre un premier et un second matériau, qui peuvent avoir été joints l'un à l'autre par un apport du second matériau sur le premier, par exemple par un dépôt, une épitaxie, etc.

En variante, une telle interface peut être, par exemple, une zone fragile formée à l'intérieur d'un matériau et matérialisée par la présence de bulles, d'inclusions, etc.

Une séparation selon une interface qui n'est pas une interface de collage peut notamment trouver application dans le transfert d'une couche d'un premier substrat vers un second substrat.

Ladite couche à transférer peut ainsi ne pas été formée par collage sur le premier substrat mais, par exemple, avoir été formée par épitaxie ou dépôt sur ledit substrat, ou, de manière alternative, faire partie d'une couche plus épaisse à l'intérieur de laquelle elle a été délimitée par une couche de bulles qui fragilise la couche épaisse.

Quelles que soient les applications envisagées, il est nécessaire d'effectuer cette séparation, sans endommager, rayer, ou contaminer la surface des deux substrats situés de part et d'autre de l'interface de séparation et sans casser ces deux substrats.

En fonction des différentes applications, ces deux "substrats à séparer" peuvent être deux couches d'un même substrat ou deux substrats distincts.

En outre, plus les dimensions des deux substrats de la structure à séparer sont importantes ou plus leur énergie de liaison est forte et plus la séparation est difficile à réaliser, notamment sans dommages.

On sait par ailleurs d'après les travaux de recherche de Maszara concernant la mesure de l'énergie de collage entre deux substrats, (voir l'article de W.P Maszara, G. Goetz, A. Caviglia et J.B McKitterick : J. Appl Phys. 64 (1988) 4943) qu'il est possible de mesurer l'énergie de collage entre deux substrats, en introduisant une lame mince entre les deux, au niveau de leur interface de collage.

Maszara a établi la relation suivante :

$$L = \sqrt[4]{\frac{3Et^3d^2}{32\gamma}}$$

dans laquelle d représente l'épaisseur de la lame insérée entre les deux substrats collés, t représente l'épaisseur de chacun des deux substrats collés, E représente le module de Young selon l'axe du décollement, $\gamma$ repré-

sente l'énergie de collage et L représente la longueur de la fissure entre les deux substrat à l'équilibre.

Dans la formule ci-dessus, on part de l'hypothèse que les deux substrats sont de dimensions identiques.

Grâce à la relation précitée, il est possible en mesurant L de déterminer l'énergie de collage $\gamma$.

Cette définition de l'énergie de « collage » repose sur l'hypothèse que l'énergie nécessaire pour séparer les deux substrats, ou énergie de rupture de l'interface (qui est l'énergie effectivement mesurée par la méthode utilisant une lame) est égale à l'énergie de collage desdits substrats.

En réalité, lors de la séparation des substrats, une partie de l'énergie est dissipée non dans la rupture de l'interface elle-même mais dans d'autres phénomènes, tels que des déformations du ou des matériaux présents à l'interface.

Dans la suite du texte, on désignera donc par énergie de rupture d'une interface l'énergie à fournir pour séparer deux substrats ou couches selon ladite interface.

Dans la mesure où les substrats ou couches à séparer présentent des rigidités suffisantes pour être séparés avec une lame, il est possible de les séparer en les écartant suffisamment l'un de l'autre, au niveau de leur bord chanfreiné, ce qui a pour effet de créer une onde de séparation.

Celle-ci se propage depuis le point du bord des substrats où elle est initiée, à travers toute la surface de ces substrats, le long de l'interface de séparation.

Lorsque la structure constituée des deux substrats ne contient qu'une interface de séparation, l'insertion d'une lame entre les deux substrats et l'application par ladite lame d'un effort d'écartement sur les substrats aura pour effet de séparer les substrats le long de ladite interface.

Cependant, on rencontre fréquemment des situations dans lesquelles la structure comporte plus d'une interface de séparation.

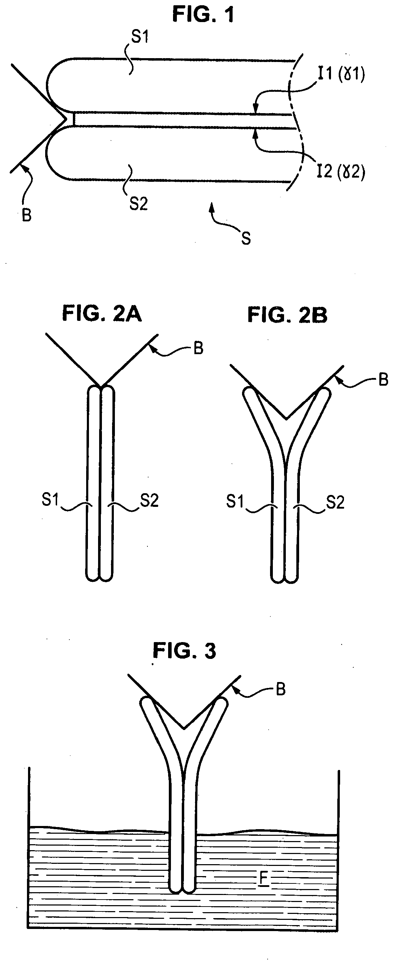

La figure 1 illustre schématiquement une telle situation, dans laquelle la structure S est formée d'un premier substrat S1 et d'un second substrat S2 et comprend deux interfaces de séparation I1, I2 présentant respectivement des énergies de rupture $\gamma_1$, $\gamma_2$.

Par exemple, les substrats S1 et S2 peuvent avoir été collés le long de l'interface I2, tandis que l'interface I1 est une interface formée lors de l'épitaxie d'un matériau sur un support, ledit matériau et le support formant ensemble le substrat S1.

Si l'énergie $\gamma_2$ est inférieure à l'énergie $\gamma_1$, lorsque l'on insère une lame B entre les deux substrats S1, S2, la séparation aura lieu préférentiellement le long de l'interface I2 présentant l'énergie de rupture la plus faible.

Or, ce n'est pas nécessairement selon cette interface que l'on souhaite effectuer la séparation.

Il peut en effet être préféré d'effectuer la séparation selon une interface dont l'énergie de rupture est plus élevée.

Cependant, le mode d'insertion de la lame ne permet pas d'influer sur l'interface selon laquelle la séparation s'initie.

Il est par ailleurs connu d'utiliser un phénomène dit de corrosion sous contrainte pour accélérer la séparation des substrats.

La corrosion sous contrainte consiste à combiner l'effort d'écartement de la lame avec l'application d'un fluide à l'interface de séparation.

La corrosion sous contrainte est particulièrement mise à profit lorsque l'un au moins des substrats est en silicium et que l'interface comprend de l'oxyde de silicium, qu'il s'agisse d'un oxyde natif ou d'un oxyde formé intentionnellement, par exemple pour former une couche de collage ou une couche isolante.

En effet, une telle interface contient des liaisons siloxane (Si-O-Si), qui sont rompues par des molécules d'eau apportées par le fluide.

L'énergie de rupture de l'interface est ainsi notablement diminuée.

Le chapitre 14, intitulé "Debonding of Wafer-Bonded Interfaces for Handling and Transfer Applications" de J. Bagdahn et M. Petzold, dans l'ouvrage "Wafer Bonding: Applications and Technology" dirigé par M. Alexe et U. Gösele, Springer, 2004, décrit ce phénomène de corrosion sous contrainte et propose différentes applications.

En particulier, ce document envisage notamment un procédé de transfert pour la réalisation de microsystèmes électromécaniques (MEMS), dans lequel on colle un substrat de type silicium sur isolant (SOI) sur un substrat de silicium présentant une cavité, puis l'on décolle le SOI le long de l'interface entre la couche mince de silicium et la couche d'oxyde enterrée.

La corrosion sous contrainte permet de réduire l'énergie de rupture de ladite interface même si, du fait d'un traitement thermique de renforcement de l'interface, elle présente initialement une énergie plus élevée que celle de l'autre interface.

Cependant, dans la mesure où l'interface entre la couche mince de silicium et la couche d'oxyde enterrée du SOI présente une énergie de rupture supérieure à celle de l'interface entre le SOI et le substrat de silicium, les auteurs n'expliquent pas comment ils parviennent à amorcer le décollement le long de cette première interface.

Par conséquent, les moyens de mise en œuvre concrète de ce procédé ne sont pas définis. US 2010/282323 A1 décrit la fabrication de substrats et plus particulièrement, une technique comprenant un procédé et un dispositif de clivage d'un substrat dans la fabrication d'un substrat silicium sur isolant notamment pour des circuits intégrés de semi-conducteurs ou des dispositifs électroniques. Le procédé comprend l'assemblage de deux substrats, des plaquettes de silicium, en structure de type sandwich, en vue de la séparation de ladite structure le long d'une interface de séparation qui est définie par implantation de particules à une profondeur déterminée dans l'épaisseur du substrat. Le substrat est un substrat de silicium et les particules implantées sont de l'hydrogène ou un gaz rare tel que l'hélium ou le néon.

Un but de l'invention est de permettre de séparer une structure comprenant plusieurs interfaces en mettant à profit la corrosion sous contrainte, mais en contrôlant, parmi ces différentes interfaces, l'interface selon laquelle la séparation doit avoir lieu.

Un but de l'invention est donc de résoudre les problèmes décrits plus haut et de proposer un procédé de fabrication d'une structure par assemblage d'au moins deux substrats, ladite structure comprenant au moins deux interfaces de séparation, permettant de sélectionner l'interface selon laquelle une séparation assistée par la corrosion sous contrainte aura lieu.

## BREVE DESCRIPTION DE L'INVENTION

Conformément à l'invention, il est proposé un procédé de fabrication d'une structure par assemblage d'au moins deux substrats, l'un au moins de ces substrats étant destiné à être utilisé dans l'électronique, l'optique, l'optoélectronique et/ou le photovoltaïque, la structure comprenant au moins deux interfaces de séparation s'étendant parallèlement aux faces principales de ladite structure, en vue d'une séparation ultérieure de ladite structure le long d'une interface choisie parmi lesdites interfaces, ladite séparation étant réalisée par l'insertion d'une lame entre lesdits substrats et l'application par ladite lame d'un effort d'écartement des deux substrats et par l'application d'un fluide à ladite interface choisie, ledit procédé étant caractérisé en ce qu'il comprend la formation de l'interface choisie pour la séparation pour laquelle on choisit les matériaux situés de part et d'autre de chacune des interfaces de séparation pour que l'interface choisie présente davantage de liaisons siloxane (Si-O-Si) que la(les) autre(s) interface(s), de sorte à ce que ladite interface soit plus sensible que la(les) autre(s) interface(s) à la corrosion sous contrainte, c'est-à-dire à l'action combinée dudit effort d'écartement et d'un fluide susceptible de rompre des liaisons siloxane présentes à ladite interface.

Dans le présent texte, le terme "substrat" couvre un substrat mono ou multicouches et dont la périphérie présente un chanfrein sur lequel une lame peut prendre appui pour provoquer l'écartement de deux substrats collés. Par ailleurs, un substrat peut lui-même contenir une ou plusieurs interfaces.

Une interface de séparation est définie dans le présent texte comme étant une frontière physique entre deux couches, selon laquelle une onde de séparation peut se propager.

Il est entendu que les deux couches en question peuvent être en deux matériaux différents, lesdits matériaux pouvant être joints par tout type d'apport d'un matériau sur l'autre (notamment épitaxie, dépôt, collage), ou bien former deux parties d'une couche plus épaisse, délimitées par une zone fragile (notamment contenant des bulles, des inclusions, etc.).

Selon un mode de réalisation, ladite interface choisie est formée entre deux matériaux dont l'un au moins est de l'oxyde de silicium.

L'autre matériau formant ladite interface choisie peut alors être choisi parmi de l'oxyde de silicium ou du silicium, éventuellement recouvert d'un oxyde natif.

Selon un mode de réalisation, ladite au moins une autre interface est formée entre deux matériaux ne contenant pas de liaisons siloxane.

De manière avantageuse, lesdits matériaux sont des métaux.

Par exemple, ladite au moins une autre interface est une interface cuivre/cuivre ou une interface titane/titane.

Un autre objet de l'invention concerne un procédé de séparation d'une structure susceptible d'être fabriquée par le procédé décrit plus haut, ledit procédé comprenant l'insertion d'une lame entre lesdits substrats et l'application par ladite lame d'un effort d'écartement des deux substrats, ledit procédé étant caractérisé en ce que l'on applique, à l'interface choisie, un fluide favorisant la corrosion sous contrainte de ladite interface.

Selon un mode de réalisation, ladite au moins une autre interface de séparation est moins sensible que l'interface choisie à la corrosion sous contrainte et, avant l'insertion de la lame entre les substrats, on met en contact lesdites interfaces en contact avec le fluide favorisant la corrosion sous contrainte.

Par exemple, avant et pendant la séparation, la structure est immergée dans un bain ou l'on projette sur la structure un fluide favorisant la corrosion sous contrainte.

Selon un mode de réalisation, ladite au moins une autre interface de séparation présente une énergie de rupture plus élevée que l'interface choisie ; la séparation comprend alors :

- une première phase d'initiation de la séparation par insertion de la lame entre les deux substrats, ladite phase étant mise en œuvre en l'absence du fluide favorisant la corrosion sous contrainte,
- une seconde phase de poursuite de la séparation, lors de laquelle on met en contact l'interface choisie avec le fluide favorisant la corrosion sous contrainte.

Pour la séparation, la structure peut être partiellement immergée dans un bain d'un fluide favorisant la corrosion sous contrainte, la lame étant insérée dans une région émergée de la structure.

Lors de la phase de poursuite de la séparation, on peut projeter un fluide favorisant la corrosion sous contrainte dans l'intervalle entre les deux substrats écartés.

De préférence, le fluide favorisant la corrosion sous contrainte est choisi parmi l'eau déionisée, l'éthanol, la vapeur d'eau, l'ammoniaque et l'hydrazine.

## BREVE DESCRIPTION DES DESSINS

D'autres caractéristiques et avantages de l'invention ressortiront de la description détaillée qui va suivre, en référence aux dessins annexés sur lesquels :

- la figure 1 est une vue en coupe d'une structure comprenant deux substrats assemblés et comportant deux interfaces de séparation ;
- les figures 2A et 2B illustrent deux étapes de la séparation d'une structure le long d'une interface ;
- la figure 3 illustre un mode de réalisation dans lequel la structure à séparer est partiellement immergée dans un bain d'un fluide favorisant la corrosion sous contrainte ;
- la figure 4 illustre un mode de réalisation dans lequel on projette un fluide favorisant la corrosion sous contrainte dans l'intervalle entre les substrats écartés ;
- les figures 5A et 5B illustrent des étapes de mise en œuvre d'un procédé de séparation selon un exemple de réalisation de l'invention.

## DESCRIPTION DETAILLEE DE L'INVENTION

### Fabrication de la structure

Revenant à la figure 1, on considère, à titre d'illustration, que la structure que l'on souhaite ensuite séparer comprend deux interfaces de séparation I1 et I2.

L'interface I1 est l'interface selon laquelle on souhaite séparer ultérieurement ladite structure.

Lors de la fabrication de la structure, on fait en sorte que l'interface I1 soit sensible à la corrosion sous contrainte.

Cet effet est obtenu par le choix de matériaux, de part et d'autre de l'interface I1, qui favorisent la corrosion sous contrainte.

Plus précisément, les matériaux choisis de part et d'autre de l'interface I1 génèrent des liaisons siloxane qui sont susceptibles d'être rompues par un fluide sous l'action d'un effort d'écartement des substrats S1 et S2.

Les interfaces qui contiennent de telles liaisons siloxane sont des interfaces mettant en jeu notamment l'oxyde de silicium ($SiO_2$), qu'il soit natif ou formé intentionnellement sur un support (par dépôt, oxydation, etc.), le silicium, lorsqu'il, est assemblé par collage hydrophile, et/ou des oxynitrures de silicium.

Les matériaux de part et d'autre de l'interface I1 peuvent être identiques ou différents, pour autant qu'il existe des liaisons siloxane entre lesdits matériaux.

Les moyens de générer une interface comprenant des liaisons siloxane sont très divers et incluent notamment des procédés de collage, de dépôt d'une couche d'oxyde, d'oxydation du silicium, de traitement du silicium par plasma oxygène, ou encore d'implantation d'oxygène.

Ainsi, l'interface I1 peut être une interface de collage, c'est-à-dire selon laquelle on a collé, lors de la fabrication de l'un des substrats ou de la structure, deux matériaux par adhésion moléculaire.

Par exemple, l'interface I1 peut être formée par collage de deux couches de silicium recouvertes chacune d'une couche d'oxyde natif par lesquelles elles sont en contact.

En variante, l'interface I1 peut être formée par collage d'une couche de silicium, éventuellement recouverte d'une couche d'oxyde natif, et d'une couche d'oxyde de silicium.

De manière alternative, l'interface I1 peut être formée par une autre technique que le collage.

Par exemple, l'interface I1 peut être formée par fragilisation d'une couche d'un matériau contenant des liaisons siloxane, par exemple par implantation ionique ou illumination laser.

D'autre part, on fait en sorte, lors de la fabrication de la structure, soit que l'interface I2 soit insensible à la corrosion sous contrainte (ou que ladite interface soit en tout état de cause moins sensible à la corrosion sous contrainte que l'interface I1 choisie pour la séparation), soit que l'interface I2 présente une énergie de rupture supérieure à celle de l'interface I1, quelle que soit la sensibilité de l'interface I2 à la corrosion sous contrainte.

Le degré de sensibilité à la corrosion sous contrainte d'un matériau peut être déterminé en mesurant la différence entre l'énergie de rupture en présence d'eau (ou d'un autre fluide favorisant la corrosion sous contrainte) et l'énergie de rupture en l'absence d'un tel fluide.

Dans le premier cas, cet effet est obtenu en choisissant des matériaux, de part et d'autre de l'interface I2, qui inhibent la corrosion sous contrainte.

Plus précisément, les matériaux choisis de part et d'autre de l'interface I2 comprennent, par rapport aux matériaux de part et d'autre de l'interface I1, moins de liaisons siloxane susceptibles d'être rompues par un fluide sous l'action d'un effort d'écartement des substrats S1 et S2.

D'une manière générale, on évite d'utiliser des matériaux contenant à la fois des atomes de silicium et d'oxygène de part et d'autre de l'interface I2.

Parmi les matériaux appropriés, on peut citer les métaux car leur collage repose sur des mécanismes dont la chimie ne met pas en jeu de liaisons siloxane. Néanmoins, d'autres matériaux que les métaux sont susceptibles de convenir à la réalisation de l'interface I2.

Les matériaux de part et d'autre de l'interface I2 peuvent être identiques ou différents, pour autant qu'il n'existe pas de liaisons siloxane entre lesdits matériaux.

L'interface I2 peut être une interface de collage, c'est-à-dire selon laquelle on a collé, lors de la fabrication de l'un des substrats ou de la structure, deux matériaux par adhésion moléculaire.

Par exemple, l'interface I2 peut être formée par collage de deux couches métalliques, de préférence du même métal, par exemple deux couches de cuivre, deux couches de titane, etc., ou bien, éventuellement, de deux métaux différents. L'interface I2 peut également être une interface entre une couche de silicium et une couche métallique.

Un collage hydrophobe de deux couches de silicium ne contient pas non plus de liaisons siloxane.

De manière alternative, l'interface I2 peut être formée par une autre technique que le collage.

Par exemple, l'interface I2 peut être formée par fragilisation d'une couche d'un matériau ne contenant pas de liaisons siloxane.

Naturellement, la structure peut comprendre plus de deux interfaces de séparation.

Dans ce cas, on fait en sorte, lors de la fabrication de la structure, que ce soit l'interface choisie pour la séparation qui soit la plus sensible à la corrosion sous contrainte, quelles que soient les énergies de rupture respectives de l'interface choisie et des autres interfaces.

De manière alternative à la conception de la(les) interface(s) autre(s) que l'interface choisie de sorte qu'elle(s) soi(en)t insensible(s) à la corrosion sous contrainte, on fait en sorte que l'énergie de rupture de l'interface choisie I1 soit inférieure à celle de la (des) autre(s) interface(s) de séparation, quelle que soit la sensibilité desdites autres interfaces à la corrosion sous contrainte.

L'homme du métier est en mesure d'estimer l'énergie de rupture d'une interface et de choisir en conséquence les matériaux adéquats, voire de mettre en oeuvre des traitements appropriés pour renforcer une interface particulière.

## Séparation de la structure

En référence à la figure 2A, la séparation consiste à insérer une lame B, de préférence épaisse, entre les deux substrats S1, S2 de la structure S, depuis la périphérie de celle-ci.

Par épaisse, on entend le fait que la lame permet un écartement important des substrats, de sorte à permettre leur séparation physique sans entrer en contact avec les faces avant (c'est-à-dire les faces desdits substrats situées à l'interface), afin d'éviter de les endommager.

Par ailleurs, la lame doit être insérée entre les substrats selon un plan parallèle au plan de l'interface de séparation.

Lors de la séparation, les substrats sont maintenus par un support agencé de telle sorte que l'un au moins des substrats soit susceptible de se déformer, afin d'éviter toute rupture des substrats.

Ainsi, selon un mode de réalisation préféré, la structure est positionnée verticalement dans un dispositif de séparation qui comprend, dans sa partie inférieure, un organe de retenue de la structure et, dans sa partie supérieure, un organe de séparation mobile en translation verticale comprenant la lame, dans l'axe de l'organe de retenue.

L'organe de retenue comprend une gorge présentant un fond et des bords inclinés de part et d'autre dudit fond. Le fond de la gorge est suffisamment large pour recevoir la structure assemblée sans exercer de contrainte sur celle-ci, tandis que les bords sont suffisamment hauts pour éviter toute chute des substrats après leur séparation.

Le déplacement de la lame en direction de l'intérieur de la structure provoque un effet de coin et l'écartement des deux parties de celle-ci (voir figure 2B).

Cet écartement des deux parties sur une longueur L a pour effet d'initier la formation d'une onde de séparation.

Dans la forme d'exécution dans laquelle seule l'interface de séparation choisie est sensible à la corrosion sous contrainte, les autres interfaces n'étant pas sensibles à ce type de corrosion, on met en contact, dans la région d'insertion de la lame, l'interface choisie avec un fluide favorisant la corrosion sous contrainte au plus tard au moment de l'insertion de la lame.

Par exemple, la structure peut être entièrement immergée dans un bain du fluide favorisant la corrosion sous contrainte.

De manière alternative, le fluide peut être projeté, de préférence de manière continue, sur la structure, notamment au niveau de la région d'insertion de la lame.

Ainsi, le fluide a pour effet, en combinaison avec l'effort d'écartement exercé par la lame, de rompre les liaisons siloxane au niveau de l'interface choisie.

Ceci a pour effet de diminuer notablement l'énergie de rupture de ladite interface choisie, les énergies de rupture des autres interfaces n'étant pas affectées par la présence du fluide.

Ainsi, quelles que soient les énergies de rupture des autres interfaces, la séparation s'initie et se poursuit préférentiellement le long de l'interface choisie, du fait de son affaiblissement.

Dans la forme d'exécution où l'interface choisie est sensible à la corrosion sous contrainte tout en présentant l'énergie de rupture la plus faible, on initie au contraire la séparation « à sec », c'est-à-dire en l'absence de tout fluide favorisant la corrosion sous contrainte dans la région d'insertion de la lame, et l'on attend que la séparation soit amorcée pour mettre en contact l'interface choisie avec un fluide favorisant la corrosion sous contrainte.

En effet, en présence de plusieurs interfaces et en l'absence d'un fluide favorisant la corrosion sous contrainte dans la région d'insertion de la lame, la séparation s'initie le long de l'interface présentant l'énergie de rupture la plus faible, à savoir, en l'espèce, l'interface choisie.

Si l'on avait mis en contact, dans la région d'insertion de la lame, l'interface choisie avec un fluide favorisant la corrosion sous contrainte dès l'insertion de la lame, ledit fluide aurait eu pour effet de diminuer l'énergie de collage des autres interfaces susceptibles d'être également sensibles à la corrosion sous contrainte, conduisant ainsi à un nivellement des énergies de rupture desdites interfaces.

En revanche, l'initiation à sec permet d'éviter un tel nivellement et d'initier la séparation selon l'interface choisie, qui présente l'énergie de rupture la plus faible.

Une fois la séparation amorcée, la mise en contact de l'interface I1 avec un fluide favorisant la corrosion sous contrainte permet de faciliter et d'accélérer la séparation en diminuant l'énergie de rupture de ladite interface.

De manière avantageuse, la structure S est maintenue en position verticale lors de la séparation.

En effet, cette position favorise le ruissellement du fluide utilisé pour la corrosion sous contrainte le long de l'interface I1.

Dans ce cas, la lame B est préférentiellement orientée verticalement et introduite au sommet de ladite structure, de sorte que l'onde séparation se déplace vers le bas en devenant horizontale au fur et à mesure qu'elle s'éloigne du point d'insertion de la lame.

Selon un mode de réalisation, illustré à la figure 3, la structure est partiellement immergée dans un bain d'un fluide F favorisant la corrosion sous contrainte.

La lame B étant introduite dans la partie émergée de la structure, l'interface choisie I1 n'est pas en contact avec le fluide lors de l'insertion de la lame.

Ce n'est que lorsque la lame a suffisamment écarté les deux substrats que le fluide peut s'insérer dans l'intervalle entre les deux substrats et provoquer la corrosion sous contrainte.

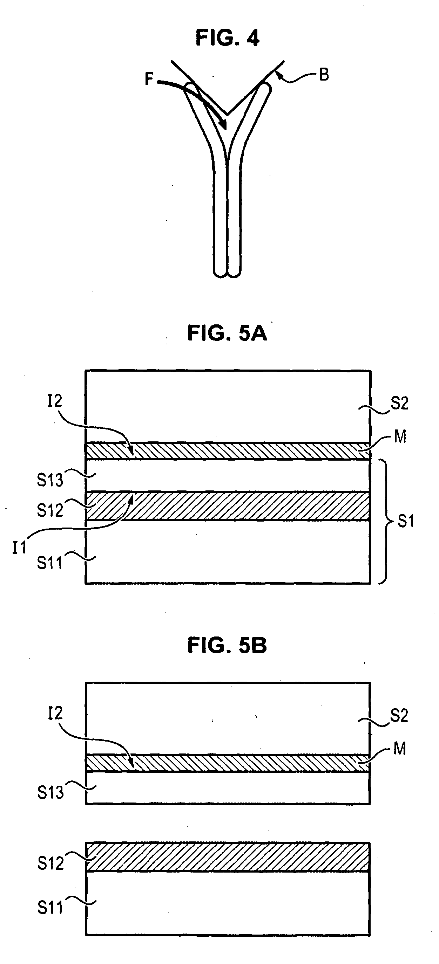

Selon un autre mode de réalisation, illustré à la figure 4, on projette un fluide F favorisant la corrosion sous contrainte dans l'intervalle entre les deux substrats une fois que la lame B a commencé à les écarter.

Parmi les fluides favorisant la corrosion sous contrainte, on peut citer, de manière non limitative, l'eau déionisée, l'éthanol, la vapeur d'eau, l'ammoniaque et l'hydrazine.

La séparation décrite ci-dessus peut être obtenue sur des structures de toutes dimensions.

Notamment, la structure peut être constituée de substrats de grand diamètre, par exemple de 300 mm de diamètre.

Exemple de mise en oeuvre

En référence à la figure 5A, on colle un substrat SOI S1 sur un substrat S2 de silicium à l'aide d'une couche de collage métallique M (du titane ou du cuivre, par exemple).

Bien que non représentés, chacun des substrats S1 et S2 présente un chanfrein sur lequel la lame de séparation peut prendre appui.

Le substrat S1 comprend successivement un substrat support S11, une couche S12 d'oxyde de silicium enterrée (usuellement désignée par le terme « BOX », acronyme de « Buried OXide » selon la terminologie anglo-saxonne) et une couche mince S13 de silicium.

Après recuit de stabilisation, l'énergie de rupture de l'interface I2 entre la couche de silicium S13 et la couche métallique M est très élevée, c'est-à-dire supérieure à l'énergie de fracture du silicium, qui est de l'ordre de $2,5$ J/m$^2$.

Par ailleurs, l'énergie de rupture de l'interface I1 entre la couche mince de silicium S13 et la couche d'oxyde enterré S12 est aussi très importante (supérieure à 2 J/m$^2$).

Notons que cette interface I1 n'a pas été obtenue par collage mais par oxydation thermique du silicium.

Toute ouverture mécanique (c'est-à-dire par exemple par introduction d'une lame en l'absence d'eau ou de tout fluide favorisant la corrosion sous contrainte) d'un tel assemblage conduirait à la rupture des substrats car les énergies de rupture des interfaces I1 et I2 sont trop élevées et trop proches de l'énergie de fracture du silicium.

En revanche, lorsque l'on plonge la structure assemblée dans l'eau lors de la séparation, l'énergie de rupture de l'interface I1 s'abaisse drastiquement car elle est sensible à la corrosion sous contrainte, mais pas celle de I2, qui y est insensible.

Grâce à la sensibilité de l'interface I1 à la corrosion sous contrainte, on obtient donc une séparation facile au niveau de ladite interface I1, provoquant ainsi le transfert de la couche mince S13 du SOI de son substrat de fabrication S11 vers un second substrat S2 (cf. figure 5B).

**Revendications**

1. Procédé de fabrication d'une structure (S) par assemblage d'au moins deux substrats (S1 , S2), l'un au moins de ces deux substrats étant destiné à être utilisé dans l'électronique, l'optique, l'optoélectronique et/ou le photovoltaïque, la structure comprenant au moins deux interfaces de séparation (I1, I2) s'étendant parallèlement aux faces principales de ladite structure, en vue d'une séparation de ladite structure (S) le long d'une interface (I1) choisie parmi lesdites interfaces, ladite séparation étant réalisée par l'insertion d'une lame (B) entre lesdits substrats (S1, S2) et l'application par ladite lame d'un effort d'écartement des deux substrats et par l'application d'un fluide à ladite interface (I1) choisie, **caractérisé en ce qu'**il comprend la formation de l'interface choisie pour la séparation pour laquelle on choisit les matériaux situés de part et d'autre de chacune des interfaces de séparation (I1, I2) pour que l'interface choisie présente davantage de liaisons siloxane, Si-O-Si, que la(les) autre(s) interfaces, de sorte à ce que ladite interface (I1) soit plus sensible que la(les) autre(s) interface(s) (I2) à la corrosion sous contrainte, c'est-à-dire à l'action combinée dudit effort d'écartement et du fluide susceptible de rompre des liaisons siloxane présentes à ladite interface (I1).

**2.** Procédé selon la revendication 1, **caractérisé en ce que** ladite interface (I1) choisie est formée entre deux matériaux dont l'un au moins est de l'oxyde de silicium.

**3.** Procédé selon la revendication 2, **caractérisé en ce que** l'autre matériau formant ladite interface (I1) choisie est choisi parmi de l'oxyde de silicium ou du silicium, éventuellement recouvert d'un oxyde natif.

**4.** Procédé selon l'une des revendications 1 à 3, **caractérisé en ce que** ladite au moins une autre interface (I2) est formée entre deux matériaux ne contenant pas de liaisons siloxane.

**5.** Procédé selon la revendication 4, **caractérisé en ce que** lesdits matériaux sont des métaux.

**6.** Procédé selon l'une des revendications 4 ou 5, **caractérisé en ce que** ladite au moins une autre interface (I2) est une interface cuivre/cuivre ou une interface titane/titane.

**7.** Procédé de séparation d'une structure (S) obtenue par le procédé selon l'une des revendications 1 à 6, ladite structure comprenant au moins deux substrats (S1 , S2) assemblés, l'un au moins de ces deux substrats étant destiné à être utilisé dans l'électronique, l'optique, l'optoélectronique et/ou le photovoltaïque, la structure comprenant au moins deux interfaces de séparation (I1, I2), la séparation étant effectuée le long d'une interface (I1) choisie parmi lesdites interfaces, ledit procédé comprenant l'insertion d'une lame (B) entre lesdits substrats (S1, S2) et l'application par ladite lame d'un effort d'écartement des deux substrats, ledit procédé étant **caractérisé en ce que** l'on applique, à l'interface (I1) choisie, le fluide favorisant la corrosion sous contrainte de ladite interface (I1).

**8.** Procédé selon la revendication 7, **caractérisé en ce que** ladite au moins une autre interface de séparation (I2) est moins sensible que l'interface (I1) choisie à la corrosion sous contrainte et **en ce qu'**avant l'insertion de la lame entre les substrats, on met en contact lesdites interfaces (I1, I2) en contact avec le fluide favorisant la corrosion sous contrainte.

**9.** Procédé selon la revendication 8, **caractérisé en, ce qu'**avant et pendant la séparation, la structure est immergée dans un bain ou l'on projette sur la structure le fluide favorisant la corrosion sous contrainte.

**10.** Procédé selon la revendication 9, **caractérisé en ce que** ladite au moins une autre interface de séparation (I2) présente une énergie de rupture plus élevée que l'interface (I1) choisie, et **en ce que** la séparation comprend :

- une première phase d'initiation de la séparation par insertion de la lame (B) entre les deux substrats, ladite phase étant mise en œuvre en l'absence du fluide favorisant la corrosion sous contrainte,
- une seconde phase de poursuite de la séparation, lors de laquelle on met en contact l'interface (I1) choisie avec le fluide favorisant la corrosion sous contrainte.

**11.** Procédé selon la revendication 10, **caractérisé en ce que** pour la séparation, la structure est partiellement immergée dans un bain du fluide favorisant la corrosion sous contrainte, et la lame est insérée dans une région émergée de la structure.

**12.** Procédé selon l'une des revendications 10 ou 11, **caractérisé en ce que** lors de la phase de poursuite de la séparation, on projette le fluide favorisant la corrosion sous contrainte dans l'intervalle entre les deux substrats écartés.

**13.** Procédé selon l'une des revendications 8 à 12, **caractérisé en ce que** le fluide favorisant la corrosion sous contrainte est choisi parmi l'eau déionisée, l'éthanol, la vapeur d'eau, l'ammoniaque, l'hydrazine.

**Patentansprüche**

**1.** Verfahren zur Herstellung einer Struktur (S) durch Zusammenbau von mindestens zwei Substraten (S1, S2), wobei mindestens eines dieser beiden Substrate für die Verwendung in der Elektronik, Optik, Optoelektronik und/oder Photovoltaik vorgesehen ist, wobei die Struktur mindestens zwei Trennzonen (I1, I2) umfasst, die sich parallel zu den Hauptflächen der Struktur erstrecken, zum Trennen der Struktur (S) entlang einer unter den Trennzonen ausgewählten Trennzone (I1), wobei die Trennung durchgeführt wird, indem eine Schneide (B) zwischen die Substrate (S1, S2) eingeführt wird und durch die Schneide eine Trennkraft aufgebracht wird, um die beiden Substrate zu trennen, und durch Aufbringen eines Fluids auf die ausgewählte Trennzone (I1), **dadurch gekennzeichnet, dass** es die Bildung der für die Trennung ausgewählten Trennzone umfasst, für die die Materialien, die sich auf beiden Seiten jeder der Trennzonen (I1, I2) befinden, so ausgewählt werden, dass die ausgewählte Trennzone mehr Siloxan, Si-O-Si, als die andere(n) Trennzone(n) aufweist, so dass die Trennzone (I1) empfindlicher als die andere(n) Trennzone(n) (I2) gegenüber Spannungsrisskorrosion ist, d. h. gegenüber der kombinierten Wirkung der Trennkraft und der Flüssigkeit, die in der Lage ist, Siloxanbindungen zu brechen, die an der genannten Trennzone (I1) vorhanden sind.

2. Verfahren nach Anspruch 1, **dadurch gekennzeichnet, dass** die ausgewählte Trennzone (I1) zwischen zwei Materialien gebildet wird, von denen mindestens eines Siliziumoxid ist.

3. Verfahren nach Anspruch 2, **dadurch gekennzeichnet, dass** das andere Material, das die ausgewählte Trennzone (I1) bildet, unter Siliziumoxid oder Silizium ausgewählt wird, gegebenenfalls beschichtet mit einem nativen Oxid.

4. Verfahren nach einem der Ansprüche 1 bis 3, **dadurch gekennzeichnet, dass** die mindestens eine weitere Trennzone (t2) zwischen zwei Materialien gebildet wird, die keine Siloxanbindungen enthalten.

5. Verfahren nach Anspruch 4, **dadurch gekennzeichnet, dass** die Materialien Metalle sind.

6. Verfahren nach einem der Ansprüche 4 oder 5, **dadurch gekennzeichnet, dass** die mindestens eine andere Trennzone (I2) eine Kupfer/Kupfer-Trennzone oder eine Titan/Titan-Trennzone ist.

7. Verfahren zur Trennung einer durch das Verfahren nach einem der Ansprüche 1 bis 6 erhaltenen Struktur (S),
wobei die Struktur mindestens zwei zusammengebaute Substrate (S1, S2) umfasst, wobei mindestens eines dieser beiden Substrate für die Verwendung in der Elektronik, Optik, Optoelektronik und/oder Photovoltaik bestimmt ist, wobei die Struktur mindestens zwei Trennzonen (I1, I2) umfasst, wobei die Trennung entlang einer unter den Trennzonen ausgewählten Trennzone (I1) durchgeführt wird,
wobei das Verfahren das Einführen einer Schneide (B) zwischen die Substrate (S1, S2) und das Aufbringen anhand der Schneide einer Trennkraft zur Trennung der beiden Substrate umfasst, wobei das Verfahren **dadurch gekennzeichnet ist, dass** auf die ausgewählte Trennzone (F1) das die Spannungsrisskorrosion der Trennzone (I1) fördernde Fluid aufgebracht wird.

8. Verfahren nach Anspruch 7, **dadurch gekennzeichnet, dass** die mindestens eine andere Trennzone (I2) gegenüber der Spannungsrisskorrosion weniger empfindlich ist, als die gewählte Trennzone (I1) und dass vor dem Einführen der Schneide zwischen die Substrate die Trennzonen (I1, I2) mit dem die Spannungsrisskorrosion fördernden Fluid in Kontakt gebracht werden.

9. Verfahren nach Anspruch 8, **dadurch gekenn-** **zeichnet, dass** die Struktur vor und während der Trennung in ein Bad getaucht wird, in dem das die Spannungsrisskorrosion fördernde Fluid auf die Struktur gesprüht wird.

10. Verfahren nach Anspruch 9, **dadurch gekennzeichnet, dass** die mindestens eine andere Trennzone (I2) eine höhere Bruchenergie als die ausgewählte Trennzone (I1) aufweist, und dass die Trennung Folgendes umfasst:

   - eine erste Phase, in der die Trennung durch Einführen der Schneide (B) zwischen die beiden Substrate eingeleitet wird, wobei die Phase in Abwesenheit des die Spannungsrisskorrosion fördernden Fluids durchgeführt wird,
   - eine zweite Phase, in der die Trennung fortgeführt wird, und die ausgewählte Trennzone (I1) mit dem die Spannungsrisskorrosion fördernden Fluid in Kontakt gebracht wird.

11. Verfahren nach Anspruch 10 10, **dadurch gekennzeichnet, dass** die Struktur zur Trennung teilweise in ein Bad des die Spannungsrisskorrosion fördernden Fluids getaucht wird und die Schneide in einen herausragenden Bereich der Struktur eingeführt wird.

12. Verfahren nach einem der Ansprüche 10 oder 11, **dadurch gekennzeichnet, dass** während der Fortführungsphase der Trennung das die Spannungsrisskorrosion fördernde Fluid in den Abstand zwischen den zwei getrennten Substrate gespritzt wird.

13. Verfahren nach einem der Ansprüche 8 bis I2, **dadurch gekennzeichnet, dass** das die Spannungsrisskorrosion fördernde Fluid unter deionisiertem Wasser, Ethanol, Wasserdampf, Ammoniak, Hydrazin ausgewählt wird.

**Claims**

1. A method for manufacturing a structure (S) by assembling at least two substrates (S1, S2), at least one of these two substrates being intended for use in electronics, optics, optoelectronics and/or photovoltaics, the structure comprising at least two separation interfaces (I1, 12) extending parallel to the main surfaces of said structure, for separating said structure (S) along an interface (I1) chosen amongst said interfaces, said separation being implemented by inserting a blade (B) between said substrates (S1, S2) and by applying a force by means of said blade for spreading the two substrates and by applying a fluid onto said chosen interface (I1), **characterized in that** it includes forming the interface chosen for the separation, by choosing the materials located on both sides of each of the separation interfaces (I1, I2) such that the chosen interface has more siloxane bonds, Si-O-Si, than the other interface(s), in order for said interface (I1) to be more sensitive to stress corrosion cracking than the other interface(s), i.e. to the combined action of said spreading force and of the fluid for breaking the siloxane bonds provided at said interface (I1).

2. The method according to claim 1, **characterized in that** said chosen interface (I1) is formed between two materials, at least one of which is silicon oxide.

3. The method according to claim 2, **characterized in that** the other material forming said chosen interface (I1) is chosen among silicon oxide or silicon, possibly covered with a native oxide.

4. The method according to one of the claims 1 to 3, **characterized in that** said at least one other interface (I2) is formed between two materials that do not contain any siloxane bonds.

5. The method according to claim 4, **characterized in that** said materials are metals.

6. The method according to one of the claims 4 or 5, **characterized in that** said at least one other interface (I2) is a copper/copper interface or a titanium/titanium interface.

7. A method for separating a structure (S) obtained using the method according to one of the claims 1 to 6, said structure comprising at least two assembled substrates (S1, S2), at least one of these two substrates being intended for use in electronics, optics, optoelectronics and/or photovoltaics, the structure comprising at least two separation interfaces (I1, I2), separation being carried out along an interface (I1) chosen amongst said interfaces, said method comprising inserting a blade (B) between said substrates (S1, S2) and applying a force for spreading the two substrates, said method being **characterized in that** the fluid promoting stress corrosion cracking of the chosen interface (I1) is applied to said interface (I1).

8. The method according to claim 7, **characterized in that** said at least one other separation interface (I2) is less sensitive to stress corrosion cracking than the chosen interface (I1) and **in that** before inserting the blade between the substrates, said interfaces (I1, I2) are brought in contact with the fluid promoting stress corrosion cracking.

9. The method according to claim 8, **characterized in that** before and during the separation, the structure is immersed in a bath in which the fluid promoting stress corrosion cracking is sprayed onto the structure.

10. The method according to claim 9, **characterized in that** said at least one other separation interface (I2) has a higher fracture energy that the chosen interface (I1) and **in that** the separation comprises:

    - a first phase of initiating the separation by inserting the blade (B) between the two substrates, said phase being carried out in the absence of the fluid promoting stress corrosion cracking,
    - a second phase of continuing the separation, in which the chosen interface (I1) is brought into contact with the fluid promoting stress corrosion cracking.

11. The method according to claim 10, **characterized in that** for separation, the structure is partially immersed into a bath of the fluid promoting stress corrosion cracking and the blade is inserted into an emerging region of the structure.

12. The method according to one of the claims 10 or 11, **characterized in that** during the continuation phase of the separation, the fluid promoting stress corrosion cracking is sprayed into the space between the two spread substrates.

13. The method according to one of the claims 8 to 12, **characterized in that** the fluid promoting stress corrosion cracking is chosen among deionized water, ethanol, water vapor, ammonia, hydrazine.

## FIG. 1

## FIG. 2A

## FIG. 2B

## FIG. 3

## FIG. 4

## FIG. 5A

## FIG. 5B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010282323 A1

**Littérature non-brevet citée dans la description**

- **W.P MASZARA ; G. GOETZ ; A. CAVIGLIA ; J.B MCKITTERICK.** *J. Appl Phys.,* 1988, vol. 64, 4943